# EUROPÄISCHE PATENTSCHRIFT

(11) **EP 1 841 069 B1**
(45) Veröffentlichungstag und Bekanntmachung des Hinweises auf die Patenterteilung: **24.02.2010**
(21) Anmeldenummer: 07006120.5
(22) Anmeldetag: 24.03.2007
(51) Int. Cl.: H03K 17/955

(54) **Apparat zum Erkennen eines Objektes im Detektionsbereich einer Sensorvorrichtung und Verfahren zu dessen Betrieb**
Apparatus for identifying an object within the detection area of a sensor device and method for its operation
Appareil de détection d'objet dans une zone de détection d'un dispositif de capteur et son procédé de fonctionnement

(30) Priorität: 30.03.2006 DE 102006015171
(43) Veröffentlichungstag der Anmeldung: 03.10.2007
(73) Patentinhaber: Huf Hülsbeck & Fürst GmbH & Co. KG, 42551 Velbert (DE)
(72) Erfinder: van Gastel, Peter, 42699 Solingen (DE)
(74) Vertreter: Lilie, Philipp

(56) Entgegenhaltungen:
- EP-A- 1 455 044
- EP-A1- 1 617 509
- DE-A1- 19 803 643

## Beschreibung

Die vorliegende Erfindung betrifft ein Verfahren zum Betrieb eines Apparates zum Erkennen eines Hindernisses im Öffnungsbereich einer Schließvorrichtung in einem Zeitintervall. Des Weiteren wird ein Apparat zum Erkennen eines Hindernisses im Öffnungsbereich einer Schließvorrichtung vorgeschlagen. Derartige Apparate und Verfahren werden insbesondere im Zusammenhang mit einem Einklemmschutz bei beweglichen Komponenten von Fahrzeugen eingesetzt.

Mit einer solchen Schutzvorrichtung soll insbesondere das Einklemmen von beispielsweise menschlichen Körperteilen zwischen bewegten Komponenten eines Kraftfahrzeuges verhindert werden. Nach der Arbeitsweise lassen sich die bekannten Vorrichtungen in direkt oder indirekt arbeitende Einklemmschutz-Vorrichtungen unterteilen. Unter einem direkt arbeitenden Einklemmschutz werden Vorrichtungen oder Systeme verstanden, die Sensoren aufweisen, welche ein Hindernis direkt erkennen und ein entsprechendes Signal an einen (beispielsweise eine Fensterscheibe antreibenden) Elektromotor übermitteln. Im Unterschied hierzu wird bei einem indirekt arbeitenden Einklemmschutz die auf den Elektromotor zur Bewegung der Fensterscheibe wirkende Last erfasst und die Anwesenheit eines Hindernisses durch die Verarbeitung der spezifischen Parameter des Elektromotors indirekt ermittelt.

Hinsichtlich der direkt arbeitenden Einklemmschutz-Vorrichtungen werden weiter taktile und berührungslos arbeitende Einklemmschutz-Vorrichtungen unterschieden. Im Rahmen eines taktilen Einklemmschutzes sind beispielsweise kompressible Materialien vorgesehen, die z.B. mit mehreren voneinander beabstandeten, elektrisch leitfähigen, Bereichen ausgeführt sind, wobei infolge eines physischen Kontaktes die leitfähigen Bereiche aneinander gedrückt werden. Aufgrund dieser Lageveränderung und/oder eines elektrischen Kontaktes dieser Bereiche kann ein entsprechendes Signal erfasst werden. Bei berührungslos arbeitenden Einklemmschutz-Vorrichtungen ist es bekannt, in die Nähe des zu überwachenden Öffnungsbereiches einen elektrischen Leiter bereitzustellen, der eine Sensorelektrode darstellt, die ein elektrisches bzw. elektromagnetisches Feld in dem Öffnungsbereich erzeugt. Nähert sich nunmehr ein Gegenstand dieser Sensorelektrode, so kann auf Basis von kapazitiv und/oder induktiv wirkenden Sensorelementen die Veränderung des umliegenden elektrischen bzw. elektromagnetischen Feldes detektiert werden.

Des Weiteren ist bereits bekannt, sowohl taktile als auch berührungslos arbeitende Einklemmschutz-Vorrichtungen bei einem Fahrzeug vorzusehen. Eine solche kombinierte Vorrichtung geht beispielsweise aus der DE 103 10 066 B3 hervor. Mit einer solchen kombinierten Vorrichtung kann erreicht werden, dass bei nicht korrekter Betriebsweise des berührungslos wirkenden Einklemmschutzes infolge eines gestörten elektromagnetischen Feldes gleichwohl ein taktiler Einklemmschutz für Körperteile oder anderen Gegenstände gewährleistet ist.

Die DE 198 03 643 A1 beschreibt eine Einrichtung für eine berührungslose Sensorerfassung, bei welcher Einflüsse durch Störsignale aufgrund externer elektromagnetischer Felder durch einen weiteren Sensor erfasst und bei der Auswertung berücksichtigt werden.

Es hat sich gezeigt, dass eine solche kombinierte Einklemmschutz-Vorrichtung bereits eine Vielzahl von möglichen Einklemmschutz-Situationen sicher erfasst werden kann. Damit ist insbesondere die Situation gemeint, bei der der berührungslos arbeitende Einklemmschutz korrekt arbeitet oder fehlerhafter Weise eine Einklemmsituation nicht erfasst (weil hier der taktile Einklemmschutz einspringt). Problematisch können jedoch die Situationen sein, bei denen infolge einer Störung des zur Überwachung erforderlichen elektrischen und/oder elektromagnetischen Feldes eine Einklemm-Situation bestimmt wird, diese jedoch tatsächlich nicht vorliegt. Das führt nun beispielsweise dazu, dass sich die Schließvorrichtung nicht automatisch bzw. elektromotorisch unterstützt schließen lässt, obwohl dies ohne Weiteres möglich wäre. Bei zu häufigen Fehlinterpretationen der tatsächlichen Situation kann es folglich zu einer beachtlichen Reduzierung des Benutzungskomforts kommen.

Selbstverständlich können diese Probleme auch im Zusammenhang mit anderen Systemen mit einer ähnlichen Sensorvorrichtung auftreten und zu einem unerwünschten Fehlverhalten führen.

Aufgabe der vorliegenden Erfindung ist es, die mit Bezug auf den Stand der Technik geschilderten Probleme zumindest teilweise zu lösen. Dabei ist insbesondere ein einwandfreier Betrieb von Sensorvorrichtungen zu gewährleisten, die das Eindringen eines Objektes in den zugehörigen Detektionsbereich feststellen sollen. Insbesondere sollen ein Verfahren und ein Apparat zur Realisierung eines Einklemmschutzes angegeben werden, wobei eine zuverlässige Interpretation der tatsächlichen Situation während des Schließvorgangs gewährleistet ist. Dabei soll der Apparat möglichst einfach aufgebaut und Platz sparend beispielsweise in einem Fahrzeug anbringbar sein. Mit dem Verfahren zum Betrieb eines solchen Apparates sollen insbesondere Plausibilitätsüberprüfungen der erfassten Signale ermöglicht werden, so dass gerade im Zusammenhang mit kapazitiv wirkenden Einklemmschutz-Vorrichtungen bei elektromagnetischen Stör-Feldern unerwünschte Fehlauslösungen des Einklemmschutzes vermieden werden.

Diese Aufgaben werden gelöst mit einem Verfahren zum Betrieb eines Apparates zum Erkennen eines Hindernisses im Öffnungsbereich einer Schließvorrichtung gemäß den Merkmalen des Patentanspruchs 1 sowie einen Apparat mit den Merkmalen des Patentanspruchs 7. Weitere vorteilhafte Ausgestaltungen sind in den jeweils abhängigen Patentansprüchen formuliert. Es ist darauf hinzuweisen, dass die in den Patentansprüchen einzeln aufgeführten Merkmale in beliebiger, technologisch sinnvoller, Weise miteinander kombiniert werden können, und weitere Ausgestaltungen der Erfindung aufzeigen.

Zunächst sei darauf hingewiesen, dass das hier vorgeschlagene Verfahren bevorzugt im Zusammenhang mit dem Erkennen von Objekten (Körperteile, Gegenstände, etc.) im Detektionsbereich einer Sensorvorrichtung für beispielsweise Parkleitsysteme, Fahrleitsysteme, Diebstahlsicherungen, Personenidentifikationssysteme, Zutrittsidentifikationssysteme, Türgriffbetätigungseinrichtungen und dergleichen zum Einsatz gelangen kann. Es bietet insbesondere den Vorteil, dass gerade (kapazitiv arbeitende) Sensorvorrichtungen, die nicht ausreichend gegen externe elektromagnetische Felder abgeschirmt werden können und/oder die so sensibel auf diese externen Felder reagieren, dass selbst Stützkondensatoren zur Kompensation des negativen Einflusses auf die Messwerterfassung nicht ausreichen, gleichwohl gefahrlos betrieben werden können, weil sie ansonsten deaktiviert sind. Auch wenn das erfindungsgemäße Verfahren nachfolgend vielfach nur im Lichte des Einklemmschutzes erläutert wird, ist dessen Anwendung im obigen Sinn ebenfalls vorteilhaft und entsprechend zu übertragen.

Das hier bevorzugt genannte Verfahren zum Erkennen eines Hindernisses im Öffnungsbereich einer Schließvorrichtung findet insbesondere Anwendung bei der Realisierung eines Einklemmschutzes im Öffnungsbereich von Schiebedächern, Seitentüren, Heckklappen, Seitenfenstern oder ähnlichen Schließvorrichtungen eines Fahrzeugs. Regelmäßig umfasst die Schließvorrichtung (elektromotorisch unterstützte) bewegte Fahrzeugkomponenten, wobei der Einklemmschutz insbesondere in der unmittelbaren Umgebung der Randbereiche des Öffnungsbereiches der Schließvorrichtung realisiert ist.

Gemäß Schritt a) wird nun zunächst mit diesem Apparat ein elektrisches oder elektromagnetisches Feld (so genanntes Messfeld) generiert, so dass ein berührungsloser Einklemmschutz verwirklicht ist. Zur Erläuterung der Wirkungsweise eines berührungslosen Einklemmschutzes kann insbesondere auf die Beschreibungen in der Einleitung zurückgegriffen werden. Das Erfassen eines Messwertes betrifft insbesondere die Bestimmung einer sich ändernden Induktivität bzw. Kapazität der Sensorelektrode und/oder damit zusammenwirkenden weiteren elektrischen bzw. elektronischen Komponenten des Apparates, wobei hierzu auch auf darauf aufbauende Parameter zurückgegriffen werden kann, wie beispielsweise Frequenzen etc. Bei einem solchen aktivierten elektrischen bzw. elektromagnetischen Feld kann ohne Weiteres das Eindringen eines Hindernisses in den Öffnungsbereich berührungslos detektiert werden, wobei für eine Identifizierung einer potentiellen Einklemm-Situationen insbesondere der Schließvorgang der Schließvorrichtung unterbrochen oder in einem anderen Betriebsmodus überführt werden kann.

Um nunmehr Fehlauslösungen im Rahmen dieser Realisierung eines berührungslosen Einklemmschutzes im Öffnungsbereich der Schließvorrichtung zu vermeiden, wird während des Schließvorgangs bzw. des vorgebbaren Zeitintervalls intermittierend ermittelt, welche externen elektromagnetischen Felder im bzw. in der Nähe des Öffnungsbereichs der Schließvorrichtung existieren (vgl. Schritt b)). Hierzu wird mindestens eine Antenne verwendet, die eine, für das externe elektromagnetische Feld charakteristische, Störgröße erfasst. Zur Charakterisierung des externen elektromagnetischen Feldes können im Wesentlichen die gleichen Parameter bestimmt werden, die auch zur Überwachung des im Rahmen des berührungslosen Einklemmschutzes generierten elektrischen bzw. elektromagnetischen Feldes herangezogen werden. Während Schritt b) wird zeitweise das selbst generierte Messfeld deaktiviert, so dass eine hiervon unabhängige Bestimmung des externen elektromagnetischen Feldes vorgenommen werden kann.

Gemäß Schritt c) wird nun diese tatsächlich erfasste Störgröße mit einer Referenzgröße verglichen. Die Referenzgröße stellt dabei regelmäßig einen Kennwert bzw. einen Kennwertbereich dar, mit dem die Grenzen eines fehlerlos arbeitenden berührungslosen Einklemmschutzes bei Vorliegen externer elektromagnetischer Felder bestimmt sind. Diese Referenzgrößen sind insbesondere im Hinblick auf die Ausgestaltung des Apparates zur Realisierung des berührungslosen Einklemmschutzes, dessen Sensibilität und den Bedingungen in der Umgebung der Schließvorrichtung anzupassen.

In Schritt d) ist nunmehr ein Abbruch-Kriterium für die Durchführung des berührungslosen Einklemmschutzes angegeben. Demnach ist dieser regelmäßig dann zu deaktivieren, wenn das Zeitintervall abgelaufen ist, also ein einwandfreier Betrieb des berührungslos arbeitenden Einklemmschutzes gewährleistet war. Das Zeitintervall erstreckt sich dabei insbesondere über den Zeitraum, in dem die Schließvorrichtung offen ist, jedenfalls jedoch über den Zeitraum des Schließvorgangs selbst. Darüber hinaus wird auch ein Abbruch des berührungslosen Einklemmschutzes bevorzugt gerade dann realisiert, wenn die Störgröße des externen elektromagnetischen Feldes von der Referenzgröße signifikant abweicht. Eine "signifikante" Abweichung liegt insbesondere dann vor, wenn die Störgröße einen Regelbereich der Referenzgröße verlassen hat, wobei hier (gegebenenfalls in Abhängigkeit von der Genauigkeit der eingesetzten Sensoren und Schaltungselemente) das Überschreiten zusätzlicher Toleranzschwellen und/oder eine Wiederholung der Abweichung binnen eines kurzen Zeitraumes gefordert werden kann. Damit wird detektiert, dass der berührungslose Einklemmschutz nunmehr nicht in der erwartet genauen Weise funktioniert und die Gefahr von Fehlinterpretationen erhöht ist. In diesem Fall wird nunmehr der berührungslose Einklemmschutz deaktiviert, wobei ggf auch nur eine andere Betriebsweise der Schließvorrichtung eingestellt werden kann.

Mit dem hier vorgeschlagenen Verfahren ist ein Schutz gegen fehlerhaftes Einsetzen des berührungslosen Einklemmschutzes bei lokal störenden, externen elektromagnetischen Feldern gegeben. Der Vorteil dieses Verfahrens liegt insbesondere darin, dass ein fehlerhaften Einsetzen des Einklemmschutzes, die bei den bekannten Systemen noch auftreten können, von vornherein ausgeschlossen werden, das heißt eine fehlerhafter interpretierte Einklemmsituation wird durch dieses System vermieden. Zudem können die Ergebnisse dieses Verfahrens, insbesondere die Störgröße, dazu verwendet werden, um beispielsweise eine akustische und/oder optische Rückmeldung an den Benutzer des Fahrzeugs weiterzugeben. Auch könnte das Erkennen eines externen störenden elektromagnetischen Feldes dazu benutzt werden, die Betriebsweise der Schließvorrichtung zu verändern, so dass eine beispielsweise für den taktilen Einklemmschutz geeignete Verfahrweise gewählt wird.

Gemäß der Erfindung wird vorgeschlagen, dass in Schritt b) die wenigstens eine Sensorelektrode des Apparates intermittierend als Antenne betrieben wird, wobei vor Durchführen des Schrittes b) demnach das elektrische oder elektromagnetische Feld deaktiviert wird und dann die Schritte a) bis c) so lange wiederholt werden, bis das Zeitintervall abgelaufen oder die Bedingung in Schritt d) erfüllt ist. Das bedeutet mit anderen Worten insbesondere, dass die Mittel zur Realisierung des Messfeldes für einen berührungslosen Einklemmschutz in vorgegebenen Zeitabschnitten eine zusätzliche bzw. andere Funktion erhalten, so dass die Sensorelektrode dann als Antenne, insbesondere Empfangsantenne, betrieben werden kann. Bei diesem Verfahren wird insbesondere sichergestellt, dass nicht gleichzeitig das selbst erzeugte elektromagnetische Feld für einen berührungslosen Einklemmschutz und das externe elektromagnetische Feld gleichzeitig für die Durchführung des Schrittes b) vorliegen. Damit können die erfassten Störgrößen eindeutig dem externen elektromagnetischen Feld zugeordnet werden. "Intermittierend" heißt in diesem Zusammenhang insbesondere, dass Schritt b) in konkreten und/oder variablen Zeitabschnitten durchgeführt wird, wobei sich die Häufigkeit insbesondere nach dem Zeitintervall, in dem ein berührungsloser Einklemmschutz realisiert werden soll, oder dem Bewegungsverhalten der Schließvorrichtung richten kann. Grundsätzlich ist natürlich auch möglich, dass vor der Durchführung des Schrittes a) bereits erstmalig eine Überprüfung des externen elektromagnetischen Feldes anhand der Schritte b) und c) veranlasst wird, um festzustellen, ob überhaupt das Aktivieren des berührungslosen Einklemmschutzes bei den herrschenden Umgebungsbedingungen im Hinblick auf das Vorliegen externer elektromagnetischer Felder sinnvoll ist.

Weiterhin wird auch vorgeschlagen, dass Schritt a) das Aufbauen eines elektromagnetischen Wechselfeldes umfasst, wobei die Sensorelektrode mit einem Schwingkreis zusammen wirkt. Damit wird eine insbesondere im Hinblick auf die elektrische bzw. elektronische Umsetzung des berührungslosen Einklemmschutzes einfache Ausgestaltung des Verfahrens vorgeschlagen. Demgemäß können auf kapazitiver oder induktiver Basis arbeitende elektrische Sensoren zum Einsatz gelangen, die einen berührungslos arbeitenden Initiator enthalten der beispielsweise einen Hochfrequenz-Oszillator in einer Sperrschwingschaltung mit einem aktivierten LC- oder RC-Schwingkreis aufweist. Handelt es sich um einen LC-Initiator, so ist die Induktivität des LC-Schwingkreises als Spule mit gerichtetem Hochfrequenzfeld ausgebildet. Wird in das Feld ein elektrisch leitendes Medium (Hindernis) gebracht, tritt eine Dämpfung im Schwingkreis auf. Bei genügend großer Dämpfung gemäß dem Abstand des Mediums von der Spule des LC-Schwingkreises reißt die Schwingung des Oszillators ab, wobei diese Zustandsänderung innerhalb einer Steuer- und/oder Auswerteeinheit (Mikrocontroller) in einen Schaltbefehl umgesetzt werden kann (Erfassen eines Messwertes). Handelt es sich um einen RC-Initiator, so ist die Sensorelektrode Teil des Kondensators des RC-Schwingkreises (bevorzugte Ausführungsvariante), dessen Kapazität sich bei der Annäherung eines Objektes mit hinreichend großer Dielektrizitätszahl an die Sensorelektrode zu ändern im Stande ist, wodurch der RC-Schwingkreis zu Schwingungen angeregt wird oder Schwingungen abreißen und die Änderung der Schwingungsamplitude z.B. in einem nachgeschalteten Hüllkurvenmodulator ausgewertet werden können. Schalter mit derartigen Sensoren besitzen insbesondere die Eigenschaft, dass der Abstand von den Materialeigenschaften unter der Beschaffenheit des zu detektierenden Körpers abhängt. Somit bewirkt die Veränderung der Kapazitäten des Öffnungsbereiches eine Veränderung der Frequenz, die dann ausgewertet werden kann (Erfassen eines Messwertes).

Im Hinblick auf die vorstehenden Ausführungen wird insbesondere vorgeschlagen, dass der Messwert eine aktuelle Eigenfrequenz des Schwingkreises ist. Dabei wird bevorzugt eine kapazitiv arbeitende Sensorelektrode eingesetzt.

Einer Weiterbildung des Verfahrens zur Folge wird Schritt b) nach einer vorgegebenen Zeitspanne oder einer Abweichung des erwarteten Messwertes initiert. Damit ist insbesondere gemeint, dass die Überprüfung externer elektromagnetischer Felder starr, d. h. von der Betriebsweise der Schließvorrichtung oder des berührungslosen Einklemmschutzes unabhängigen Weise vorgenommen werden kann. Möglich ist auch, dass die Betriebsweise der Schließvorrichtung oder des berührungslosen Einklemmschutzes mit einbezogen werden kann, so dass bei Vorliegen bestimmter Betriebssituationen (beispielsweise bei der Identifizierung einer potentiellen Einklemmsituation) die Störgröße ermittelt wird. Selbstverständlich sind auch kombinierte Verfahren möglich.

Vorteilhaft ist es weiterhin, wenn Schritt b) für eine Prüfdauer von wenigen Millisekunden, insbesondere nicht mehr als 10 Millisekunden durchgeführt wird. Dies betrifft insbesondere den Fall, wenn die Sensorelektrode als Antenne benutzt wird. Auf diese Weise wird sichergestellt, dass der berührungslose Einklemmschutz nur für einen sehr kurzen Zeitraum deaktiviert ist, wobei in diesem Zeitintervall gegebenenfalls die Schließvorrichtung gestoppt oder verlangsamt werden kann, um die Gefahr eines plötzlich auftretenden Einklemmfalls zu vermeiden.

Um weiterhin einen sehr einfachen Schaltungsaufbau für einen solchen Einklemmschutz zu realisieren wird auch vorgeschlagen, dass die Störgröße eine Frequenz des externen elektromagnetischen Feldes ist. Damit können gegebenen Auswerteeinheiten teilweise mitbenutzt werden.

Einer weiteren Ausgestaltung des Verfahrens zufolge ist zumindest während des Zeitintervalls nach Abbruch des Schrittes a) zusätzlich eine taktile Sensoreinheit in der Umgebung des Öffnungsbereichs aktiviert. Insbesondere wird mit solchen taktilen Sensoreinheiten im Wesentlichen der gesamte Umfangsbereich des zu überwachenden Öffnungsbereichs mit den taktilen Sensoreinheiten überwacht. Diese gewährleisten zumindest für den Fall, dass der berührungslos arbeitende Einklemmschutz nicht aktiv ist, gleichwohl ein Einklemmfall eindeutig identifiziert werden kann und der Schließvorgang notfalls unterbrochen wird. Ganz besonders bevorzugt sind die taktilen Sensoreinheiten während eines gesamten Schließvorgangs der Schließvorrichtung aktiviert.

Einem weiteren Aspekt der Erfindung zufolge wird auch ein Apparat zum Erkennen eines Hindernisses im Öffnungsbereich einer Schließvorrichtung, vorgeschlagen, der die in Anspruch 7 enthaltenen Elemente umfasst.

Zur näheren Charakterisierung der hier aufgeführten Komponenten kann insbesondere auf die vorstehenden Erläuterungen Bezug genommen werden. Ergänzend ist insbesondere anzumerken, dass die Sensorelektrode bevorzugt eine kapazitiv wirkende Sensorelektrode ist.

Im Hinblick auf eine bevorzugte Ausgestaltung des Apparates liegt eine Schaltungsanordnung vor, so dass die Sensorelektrode zeitweise als Teil eines elektrischen Schwingkreises und zeitweise als Antenne betreibbar ist. Dabei ist in dem erstgenannten Zeitabschnitt die Sensorelektrode als Teil eines Kondensators eines RC-Schwingkreises zu betreiben. Während des Betriebes als Antenne kann die Sensorelektrode ebenfalls mit einem (bzw. dem selben) Schwingkreis zusammenwirken, insbesondere nach Art einer so genannten Dipolantenne, wobei eine Empfangsantenne gebildet ist.

Des Weiteren wird vorgeschlagen, dass bei dem Apparat zusätzlich eine taktile Sensoreinheit in der Umgebung des Öffnungsbereichs vorgesehen ist. Selbstverständlich können auch mehrere taktile Sensoreinheiten bereitgestellt werden. Damit ist gewährleistet, dass im Falle einer Deaktivierung des berührungslosen Einklemmschutz gleichwohl Vorsorge für einen Einklemmfall getroffen ist. Diese übernehmen dann als taktiler Einklemmschutz die Überwachungsfunktion des Öffnungsbereiches.

Des Weiteren wird auch vorgeschlagen, dass die Antenne über einen A/D-Wandler mit einem Mikrocontroller verbunden ist, der eine Störgröße des externen elektromagnetischen Feldes erfasst. Dabei werden die mit der Antenne erfassten analogen Störgrößen in digitale Daten umgesetzt (Analog-Digital-Wandler), welche dann in dem Mikrocontroller weiterverarbeitet und/oder gespeichert werden können. Auf diese Weise ist ein sehr kompakter Aufbau für eine Datenverarbeitungsanlage gegeben, der eine sichere Analyse des externen elektromagnetischen Feldes dauerhaft gewährleistet.

Die hier vorgeschlagenen Ausführungsvarianten des Apparates sind insbesondere zur Durchführung eines der zuvor erfindungsgemäß beschriebenen Verfahren geeignet, so dass die Kombination aus Apparat und Betriebsverfahren besonders vorteilhaft ist.

Schließlich wird auch vorgeschlagen, ein Kraftfahrzeug mit zumindest einem solchen Apparat auszuführen, wobei dann als Schließvorrichtung insbesondere Schiebedächer, Seitentüren, Heckklappen, Seitenfenster und dergleichen in Betracht kommen. Weitere Anwendungsfälle für das Verfahren und den Apparat sind im Zusammenhang mit dem Kraftfahrzeug insbesondere Sensorvorrichtungen für Einparkhilfen, Zutrittsidentifikationssysteme, Türgriffbetätigungseinrichtungen und dergleichen.

Die Erfindung sowie das technische Umfeld werden nun anhand der Figuren näher erläutert. Es ist darauf hinzuweisen, dass die Figuren besonders bevorzuge Ausführungsvarianten der Erfindung zeigen, diese jedoch nicht darauf beschränkt ist. Es zeigen schematisch:
- Fig. 1:: ein Kraftfahrzeug mit einer Ausführungsvariante des erfindungsgemäßen Apparates, und
- Fig. 2:: eine Schaltungsanordnung für den Betrieb einer weiteren besonders bevorzugten Ausführungsvariante des Apparates.

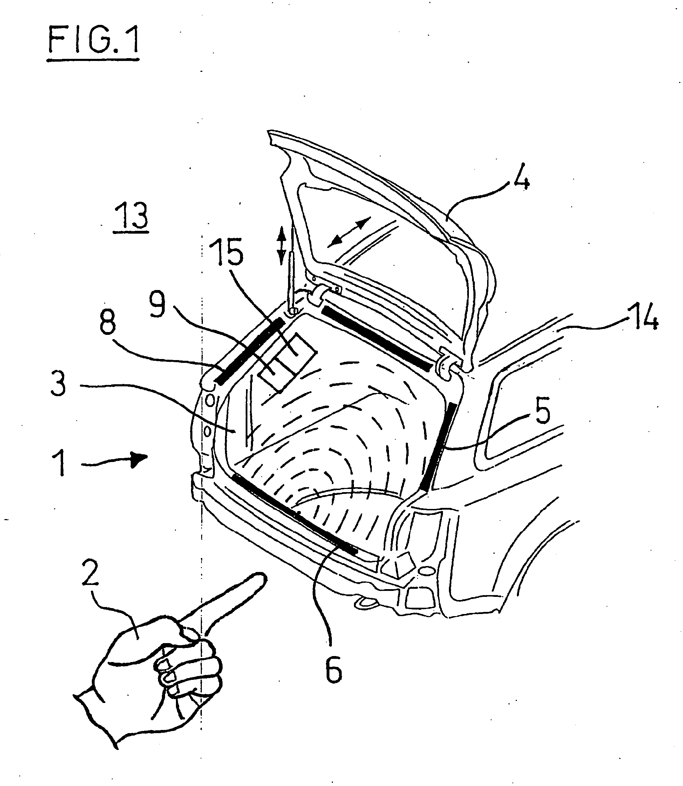

Die Fig. 1 zeigt teilweise perspektivisch ein Kraftfahrzeug 14 mit einer Schließvorrichtung 4 in Gestalt einer Heckklappe. In der Darstellung ist die Schließvorrichtung 4 geöffnet, so dass der Öffnungsbereich 3 erkennbar ist. Um diesen Öffnungsbereich 3 herum sind eine Mehrzahl von Sensorelektroden 5 vorgesehen, so dass im Wesentlichen über den gesamten Öffnungsbereich 3 das Eindringen eines Hindernisses 2 erkannt werden kann. Die Sensorelektroden 5 können teilweise auch mit taktilen Sensoreinheiten 8 kombiniert sein, wobei die Sensorelektrode 5 bevorzugt kapazitiv wirkt. Der Apparat 1 zum Erkennen des Hindernisses 2, hier beispielsweise eine Hand, umfasst dabei auch eine Steuerungseinheit 9 für beispielsweise die Sensorelektroden 5, die gegebenenfalls mit einem Antrieb 15 für die Schließvorrichtung 4 zusammenwirken kann.

Bei der hier veranschaulichten Ausführungsvariante des Apparates 1 ist nunmehr eine der Sensorelektroden als Antenne 6 zur Identifikation eines externen elektromagnetischen Feldes im Öffnungsbereich 3 ausgeführt. Wird also beispielsweise die Schließvorrichtung 4 geschlossen, wird zunächst ein elektromagnetisches Feld (so genanntes Messfeld) mittels der um den Öffnungsbereich 3 positionierten Sensorelektroden 5 aktiviert, so dass ein Messwert zur Bereitstellung eines berührungslosen Einklemmschutzes erzeugt und an die Steuerungseinheit 9 weitergeleitet wird. Nach einer vorgegebenen Zeitspanne wird nunmehr das elektromagnetische Feld deaktiviert und die unten dargestellte Sensorelektrode kurzzeitig als Antenne 6 betrieben, wobei eine Störgröße des externen elektromagnetischen Feldes in der Umgebung 13 des Fahrzeugs 4 nahe des Öffnungsbereiches 3 bestimmt wird. Auch diese Störgröße wird gegebenenfalls an die Steuerungseinheit 9 weitergeleitet und dort verarbeitet. Liegt die erfasste Störgröße in einem tolerierbaren Referenzbereich, wird wiederum das elektromagnetische Feld aktiviert und der Schließvorgang weiter durchgeführt. Sollte nunmehr im Rahmen dieses berührungslosen Einklemmschutzes durch Eingreifen des Hindernisses 2 in den Öffnungsbereich 3 eine Einklemmsituation identifiziert werden, erfolgt hier noch einmal eine kurzzeitige Plausibilitätsüberprüfung in der Weise, dass die Sensorelektrode erneut als Antenne 6 betrieben wird. Damit ist ein redundantes System angegeben.

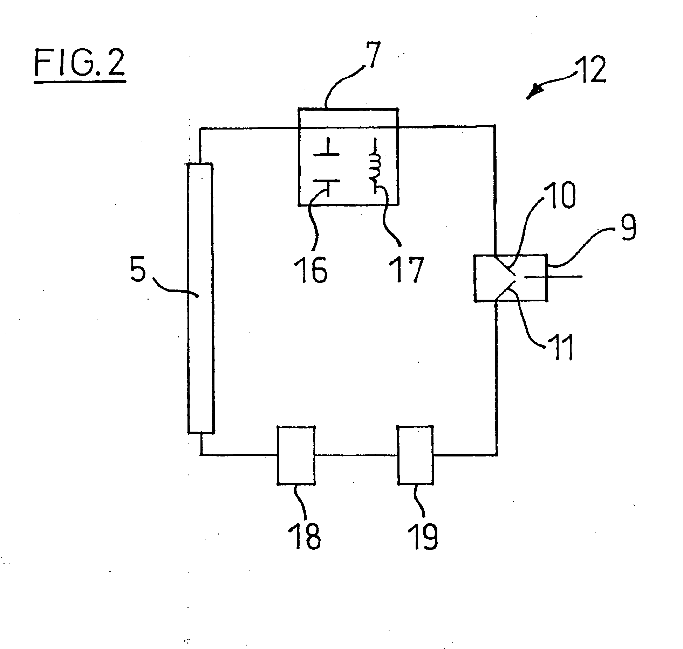

Fig. 2 veranschaulicht schematisch einen möglichen Aufbau für eine Schaltungsanordnung 12 zum Betrieb der Sensorelektrode 5 intermittierend als Antenne. Dabei stellt die Sensorelektrode 5 eine kapazitive Komponente 5 für einen Schwingkreis 7 dar, der mit einem Kondensator 16 und einer Spule 17 ausgeführt ist. Die Ansteuerung der Sensorelektrode 5 erfolgt mit den Aktivierungsmitteln 10 bzw. Deaktivierungsmitteln 11 der Steuerungseinheit 9. Für den Fall, dass die Sensorelektrode 5 als Antenne betrieben wird, werden die damit generierten Störgrößen einem A/D-Wandler 18 und anschließend einem Mikrocontroller 19 zugeführt, wobei deren Position hier rein schematisch vor der Steuerungseinheit 9 dargestellt ist. Grundsätzlich ist bei dieser schematischen Darstellung darauf hinzuweisen, dass die Sensorelektrode 5 mehrteilig aufgeführt sein kann, und somit insbesondere auch mehrere Bauteile zur Realisierung einer kapazitiven Sensorelektrode 5 bzw. einer Antenne umfassen kann. Auch stellen die Verbindungslinien zwischen den Komponenten nicht zwangsläufig separate elektrische Leiter dar, diese sollen jeweils nur erkennen lassen, welche Teile miteinander zusammenwirken.

Mit der hier veranschaulichten Ausgestaltung eines Apparates wird in einfacher Weise die Detektierung eines möglicherweise den berührungslosen, kapazitiv arbeitenden, Einklemmschutz beeinflussenden elektrischen Feldes erreicht. Diese Informationen können beispielsweise dazu eingesetzt werden, die Benutzer im Umfeld akustisch und/oder optisch davon in Kenntnis zu setzen, dass unter Umständen ein einwandfreier berührungsloser Einklemmschutz nicht gewährleistet werden kann. Dies kann bis zur Deaktivierung des berührungslosen Einklemmschutzes führen. Zudem können die Informationen hinsichtlich des externen elektromagnetischen Feldes auch für andere Komponenten am Fahrzeug bereitgestellt werden, die im Hinblick auf das Vorliegen elektromagnetischer Felder sensibel sind.

### Bezugszeichenliste

- 1: Apparat
- 2: Hindernis
- 3: Öffnungsbereich
- 4: Schließvorrichtung
- 5: Sensorelektrode
- 6: Antenne
- 7: Schwingkreis
- 8: taktile Sensoreinheit
- 9: Steuerungseinheit
- 10: Aktivierungsmitteln
- 11: Deaktivierungsmittel
- 12: Schaltungsanordnung
- 13: Umgebung
- 14: Kraftfahrzeug
- 15: Antrieb
- 16: Kondensator
- 17: Spule
- 18: A/D-Wandler
- 19: Mikrocontroller

## Patentansprüche

1. Verfahren zum Betrieb eines Apparates (1) zum Erkennen eines Hindernisses (2) im Öffnungsbereich (3) einer Schliessvorrichtung (4), in einem Zeitintervall, umfassend zumindest folgende Schritte:
a) Aktivieren eines elektrischen oder elektromagnetischen Feldes mittels wenigstens einer Sensorelektrode (5) des Apparates (1) und Erfassen eines Messwertes zum Erkennen eines Objektes, zur Bereitstellung eines berührungslosen Einklemmschutzes im Öffnungsbereich (3) der Schliessvorrichtung (4);
b) Deaktivieren des elektrischen oder elektromagnetischen Feldes und Ermitteln eines externen elektromagnetischen Feldes mittels der intermittierend als Antenne (6) betriebenen Sensorelektrode (5) und Erfassen einer Störgröße;
c) Vergleichen der Störgröße mit einer Referenzgröße;
d) Wiederholen der Schritte a) bis c) bis das Zeitintervall abgelaufen ist oder die Störgröße von der Referenzgröße abweicht.

2. Verfahren nach Patentanspruch 1, bei dem Schritt a) das Aufbauen eines elektromagnetischen Wechselfeldes umfasst, wobei die Sensorelektrode (5) mit einem Schwingkreises (7) zusammenwirkt.

3. Verfahren nach Patentanspruch 2, bei dem der Messwert eine aktuelle Eigenfrequenz des Schwingkreises (7) ist.

4. Verfahren nach einem der vorhergehenden Patentansprüche, bei dem Schritt b) nach einer vorgegebenen Zeitspanne oder einer Abweichung des erwarteten Messwertes initiiert wird.

5. Verfahren nach einem der vorhergehenden Patentansprüche, bei dem die Störgröße eine Frequenz des externen elektromagnetischen Feldes ist.

6. Verfahren nach einem der vorhergehenden Patentansprüche, bei dem zumindest während des Zeitintervalls nach Abbruch des Schrittes a) zusätzlich eine taktile Sensoreinheit (8) in der Umgebung des Öffnungsbereiches (3) aktiviert ist.

7. Apparat (1) zum Erkennen eines Hindernisses (2) im Öffnungsbereich (3) einer Schliessvorrichtung (4), umfassend wenigstens
- eine Sensorelektrode (5) zur Erzeugung eines elektrischen oder elektromagnetischen Feldes im Öffnungsbereich (3) für einen berührungslosen Einklemmschutz,
- eine mit der Sensorelektrode gekoppelte Schaltungsanordnung (12), mit der die wenigstens eine Sensorelektrode (5) zeitweise als Teil eines elektrischen Schwingkreises (7) und zeitweise als Antenne (6) zur Identifikation eines externen elektromagnetischen Feldes im Öffnungsbereich (3)betreibbar ist
- eine Steuerungseinheit (9) mit Aktivierungsmitteln (10) und Deaktivierungsmitteln (11) zum Betreiben der Sensorelektrode (5) entweder als Teil eines elektrischen Schwingkreises oder als Antenne (6).

8. Apparat (1) nach Patentanspruch 7, bei dem zusätzlich eine taktile Sensoreinheit (8) in der Umgebung (13) des Öffnungsbereich (3) vorgesehen ist.

9. Apparat (1) nach einem der Patentansprüche 7 bis 8, bei dem die Antenne (6) über einem A/D-Wandler (18) mit einem Mikrocontroller (19) verbunden ist, der eine Störgröße des externen elektromagnetischen Feldes erfasst.

## Claims

1. A method of operating an apparatus (1) for detecting an obstacle (2) in the opening region (3) of a closure device (4) within a time period including at least the following steps:
a) Activating an electric or electromagnetic field by means of at least one sensor electrode (5) of the apparatus (1) and detecting a measured value for detecting an object for providing contactless protection against trapping in the opening region (3) of the closure device (4).
b) Deactivating the electric or electromagnetic field and detecting an external or electromagnetic field by means of the sensor electrode, which is operated intermittently as an antenna (6), and detecting a disturbance parameter;
c) Comparing the disturbance parameter with a reference parameter;
d) Repeating steps a) and c) until the time period has expired or the disturbance parameter differs from the reference parameter.

2. A method as claimed in Claim 1, in which step a) includes the creation of an alternating electromagnetic field, wherein the sensor electrode (5) cooperates with a resonant circuit (7).

3. A method as claimed in Claim 2 in which the measured value is an actual natural frequency of the resonant circuit.

4. A method as claimed in one of the preceding claims, in which step b) is initiated after a predetermined period of time or a deviation of the expected measured value.

5. A method as claimed in one of the preceding claims, in which the disturbance parameter is a frequency of the external magnetic field.

6. A method as claimed in one of the preceding claims, in which, at least during the period of time, a tactile sensor unit (8) is additionally activated in the vicinity of the opening region (3) after termination of step a).

7. Apparatus (1) for detecting an obstacle (2) in the opening region (3) of a closure device (4) including at least
- a sensor electrode (5) for producing an electric or electromagnetic field in the opening region (3) for contactless protection against trapping,
- a circuit arrangement (12), which is coupled to the sensor electrode and with which the at least one sensor electrode (5) is operable intermittently as a portion of an electrical resonant circuit (7) and intermittently as an antenna (6) for the identification of an external electromagnetic field in the opening region (3)
- a control unit (9) with activating means (10) and deactivating means (11) for operating the sensor electrode (5) either as a portion of an electrical resonant circuit or as an antenna (6).

8. Apparatus (1) as claimed in Claim 7, in which a tactile sensor unit (8) is additionally provided in the vicinity (13) of the opening region (3).

9. Apparatus (1) as claimed in one of Claims 7 to 8, in which the antenna (6) is connected via an A/D converter (18) to a microcontroller (19), which detects a disturbance parameter of the external electromagnetic field.

## Revendications

1. Procédé pour le fonctionnement d'un appareil (1) pour la reconnaissance d'un obstacle (2) dans le champ d'ouverture (3) d'un dispositif de fermeture (4), dans un intervalle de temps, comprenant au moins les étapes suivantes:
a) activation d'un champ électrique ou électromagnétique par au moins une électrode (5) de l'appareil (1), et saisie d'une valeur mesurée servant à la reconnaissance d'un objet, pour permettre, sans contact physique, une protection contre le coincement dans le champ d'ouverture (3) du dispositif de fermeture (4);
b) désactivation du champ électrique ou électromagnétique et détection d'un champ électromagnétique externe au moyen d'une électrode de détection (5) fonctionnant en discontinu comme antenne (6) et saisie d'une grandeur de perturbation;
c) comparaison de la grandeur de perturbation à une valeur de référence;
d) répétition des étapes a) à c) jusqu'à ce que l'intervalle de temps soit écoulé ou que la grandeur de perturbation s'écarte de la valeur de référence.

2. Procédé selon la revendication 1 dans lequel l'étape a) comprend l'établissement d'un champ électromagnétique alternatif, alors que l'électrode de détection (5) coopère avec un circuit oscillant (7).

3. Procédé selon la revendication 2 dans lequel la valeur mesurée est une fréquence propre et effective du circuit oscillant (7).

4. Procédé selon l'une des revendications précédentes dans lequel l'étape b) est initialisée après un laps de temps prédéfini ou après un écart par rapport à la valeur mesurée attendue.

5. Procédé selon l'une des revendications précédentes dans lequel la grandeur de perturbation est une fréquence du champ électromagnétique externe.

6. Procédé selon l'une des revendications précédentes dans lequel, au moins pendant l'intervalle de temps suivant l'interruption de l'étape a), une unité de détection tactile (8) set activée en complément dans l'environnement du champ d'ouverture (3).

7. Appareil (1) servant à la reconnaissance d'un obstacle (2) dans le champ d'ouverture (3) d'un dispositif de fermeture (4) comprenant au moins
- une électrode de détection (5) pour la production d'un champ électrique ou électromagnétique dans le champ d'ouverture (3) pour une protection contre le coincement, sans contact physique,
- un arrangement de circuit (12) couplé à l'électrode de détection au moyen duquel au moins une électrode de détection (5) peut fonctionner tantôt comme partie d'un circuit oscillant électrique (7) et tantôt comme antenne (6) pour l'identification d'un champ électromagnétique externe dans le champ d'ouverture (3)
- une unité de commande (9) avec des moyens d'activation (10) et de désactivation (11) pour le fonctionnement de l'électrode de détection (5), soit comme partie d'un circuit oscillant électrique, soit comme antenne (6).

8. Appareil (1) selon la revendication 7 dans lequel une unité de détection tactile (8) est prévue en complément dans l'environnement (13) du champ d'ouverture (3).

9. Appareil selon l'une des revendications 7 à 8, dans lequel l'antenne (6) est reliée au moyen d'un convertisseur analogique-numérique (18) à un microcontrôleur (19) qui saisit une grandeur de perturbation du champ électromagnétique externe.
